Europäisches Patentamt

European Patent Office

Office européen des brevets

(11) Publication number: **0 387 833**
**A1**

# EUROPEAN PATENT APPLICATION

(21) Application number: **90104812.4**

(22) Date of filing: **14.03.90**

(51) Int. Cl.⁵: **H01L 29/796, G11C 19/28**

(30) Priority: **14.03.89 JP 61637/89**

(43) Date of publication of application:
**19.09.90 Bulletin 90/38**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Fujita, Katsuji, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Semiconductor device having charge transfer device and its peripheral circuit formed on semiconductor substrate.

(57) A buried layer (14) of a second conductivity type is formed in a semiconductor substrate (10) of a first conductivity type, and an epitaxial layer (15) of the first conductivity type is formed on the semiconductor substrate (10) and the buried layer (14). A diffusion layer (16) of the second conductivity type is formed in the epitaxial layer (15) to contact the peripheral portion of the buried layer (14), and a charge transfer device (11) is formed in a surface region of an epitaxial layer (15A) surrounded by the diffusion layer (16). A peripheral circuit of the charge transfer device (11) is formed on a region of the epitaxial layer (15) which is not surrounded by the diffusion layer (16) of the second conductivity type. The diffusion layer (16) of the second conductivity type is set at a potential (Vss) higher than that of the epitaxial layer (15A), and a clock signal leaked from the peripheral circuit (12) is ejected from the semiconductor device through the diffusion layer (16) of the second conductivity type.

F I G. 1

F I G. 3

## Semiconductor device having charge transfer device and its peripheral circuit formed on semiconductor substrate

The present invention relates to a semiconductor device having on a semiconductor substrate a charge transfer device for delaying a video signal, as well as peripheral circuits such as a filter circuit.

As a charge transfer device (CTD), a charge-coupled device (CCD) is known. The CCD is constituted by arranging a plurality of MOS capacitors in an array, and a clock signal for transferring a charge to each of transfer gates formed on the MOS capacitors is supplied to the CCD.

In the above arrangement, a charge injected in a MOS capacitors is accumulated as a unit of charge in a potential well formed by applying the clock signal to the transfer gate on the MOS capacitor array. This charge is transferred by a next clock signal to a potential well formed below the next transfer gate. These operations are sequentially repeated, and the charge supplied to the MOS capacitor is sequentially transferred.

CCDs are generally employed in delay circuits for TV sets, VCRs, or the like, or in various filter circuits.

A CCD has a function for accumulating/transferring a charge, as described above, but cannot operate by itself. Therefore, a CCD is used in combination with a peripheral circuit constituted by, e.g., MOSFETs. In this case, the CCD and the peripheral circuit are monolithically formed on the same substrate. The CCD and the peripheral circuit are generally isolated from each other by a channel stopper which is a region having a higher impurity concentration than that of the substrate. This channel stopper prevents polarity inversion on the surface of the substrate, and is useful to suppress a leakage current. However, by using only the channel stopper, the clock signal for transferring charges may be leaked to adversely affect the CCD.

The leakage of the clock signal means that a potential of a diffusion layer, which constitutes an output section of a clock signal buffer circuit for generating a clock signal supplied to each transfer gate, changes so that the clock signal leaks to the CCD through the substrate. In particular, in an n-channel CCD, a parasitic capacitor is formed by an n-p reverse bias, and the clock signal may leak to the CCD from the peripheral circuit through the substrate.

When the leakage of the clock signal occurs, the clock signal leaks, for example, from the clock signal buffer circuit for driving the CCD, which serves as a peripheral circuit, into an output portion of the CCD. Thus, the clock signal may frequently leak at an output terminal of the CCD, and high-frequency characteristics may be degraded.

It is an object of the present invention to provide a semiconductor device which can prevent leakage of a clock signal from a peripheral circuit to a CCD owing to capacitive coupling between a charge transfer device and a substrate, can prevent an increase in leakage of a clock signal to the CCD formed on the same substrate as the peripheral circuit and degradation of high-frequency characteristics, and can form a monolithic structure of the charge transfer device and the peripheral circuit.

The present invention can be achieved with the following arrangement.

A semiconductor device having a charge transfer device, comprises:
a semiconductor substrate of a first conductivity type;
a buried layer of a second conductivity type formed in the semiconductor substrate;
an epitaxial layer of the first conductivity type formed on the semiconductor substrate and the buried layer;
a diffusion layer of the second conductivity type formed in the epitaxial layer to contact the peripheral portion of the buried layer;
a charge transfer device formed in the epitaxial layer surrounded by the diffusion layer; and
means for biasing the diffusion layer and the buried layer connected to the diffusion layer to a potential higher than that of the epitaxial layer.

According to the present invention, the epitaxial layer of the first conductivity type on which the charge transfer device is formed is surrounded by the diffusion layer of the second conductivity type to set the diffusion layer at a potential higher than that of the epitaxial layer on which the charge transfer device is formed. Therefore, a clock signal leaked from the peripheral circuit to the charge transfer device is absorbed through the diffusion layer, and the charge transfer device formed on the same substrate as the peripheral circuit cannot be adversely affected.

This invention can be more fully understood from the following detailed description when taken in conjunction with the accompanying drawings, in which:

Fig. 1 is a plan view showing an arrangement of a semiconductor device according to an embodiment of the present invention;

Fig. 2 is a plan view showing an arrangement of a region including the n-channel CCD shown in Fig. 1;

Fig. 3 is a sectional view taken along a line 3-3 in Fig. 2;

Fig. 4 shows a circuit equivalent to the CCD and buffer circuit shown in Fig. 1;

Fig. 5 shows another embodiment of the peripheral circuit shown in Fig. 1; and

Fig. 6 shows a modification of the equivalent circuit shown in Fig. 4.

A preferred embodiment of the present invention will be described below with reference to the accompanying drawings.

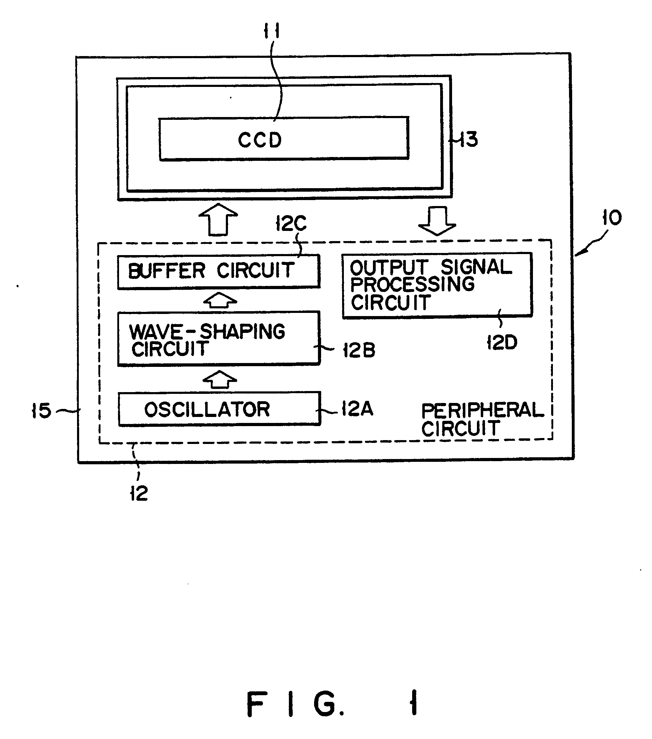

Referring to Fig. 1, an n-channel CCD 11 and a peripheral circuit 12 for driving the n-channel CCD 11 and for processing a signal output from the CCD 11 are arranged on a substrate 10. The CCD 11 is surrounded by a separate region 13 to be isolated from the peripheral circuit 12.

The CCD 11 constitutes a delay circuit used for, e.g. a TV set or a VCR. The peripheral circuit 12 includes an oscillator 12A, a wave-shaping circuit 12B for producing a clock signal with an output signal of the oscillator 12A, a buffer circuit 12C for supplying a clock signal output from the wave-shaping circuit 12B to the CCD 11, and an output signal processing circuit 12D for processing the signal output from the CCD 11.

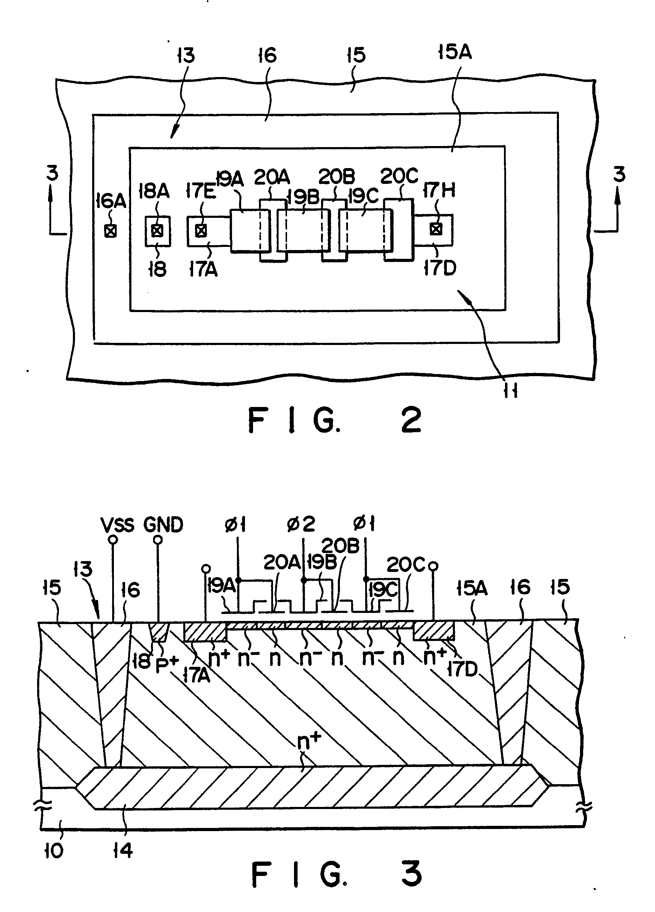

An arrangement of the CCD 11 will be described with reference to Figs. 2 and 3.

A high-concentration $n^+$-type buried layer 14 is formed in the p-type Si substrate 10. A p-type epitaxial layer 15 is formed on the p-type Si substrate 10 in which the high-concentration $n^+$-type buried layer 14 is formed. In this p-type epitaxial layer 15, a high-concentration $n^+$-type diffusion layer 16 is formed to contact the peripheral portion of the high-concentration $n^+$-type buried layer 14. The n-channel CCD 11 is formed in a region of the p-type epitaxial layer 15 surrounded by the high-concentration $p^+$-type diffusion layer 16 and the high-concentration $p^+$-type buried layer 14. The high-concentration $p^+$-type diffusion layer 16 and the high-concentration $n^+$-type buried layer 14 constitute the separate region 13. In Fig. 2, a region of the p-type epitaxial layer 15 surrounded by the diffusion layer 16 is illustrated as a p-type epitaxial layer 15A.

As shown in Fig. 3, the n-channel CCD 11 is formed on the p-type epitaxial layer 15A isolated from the p-type epitaxial layer 15.

That is, high-concentration $n^+$-type diffusion layers 17A and 17D are formed on the p-type epitaxial layer 15A with predetermined intervals. In addition, an outputting region 18 consisting of a high-concentration $p^+$-type electrode is formed in the p-type epitaxial layer 15A near the diffusion layer 17A.

First transfer gates 19A to 19C are formed on that portion of p-type epitaxial layer 15A which is located between the high-concentration $n^+$-type diffusion layers 17A and 17D, with a gate insulation film (not shown) interposed the first transfer gates 19A to 19C and the layer 15A. Second transfer gates 20A to 20C are formed so as to partly overlap the first transfer gates 19A to 19C. A clock signal $\phi 1$ is supplied to the first transfer gate 19A and the second transfer gate 20A, and a clock signal $\phi 2$ is supplied to the first transfer gate 19B and the second transfer gate 20B. The clock signal $\phi 1$ is supplied to the first transfer gate 19C and the second transfer gate 20C.

A low-concentration $n^-$-type layer is formed in that portion of the p-type epitaxial layer 15A which is located under the first transfer gates 19A to 19C. An $n^-$-type layer, which has a concentration higher than that of the $n^-$-layer and lower than that of the $n^+$-layer, is formed in that portion of the p-type epitaxial layer 15A which is located under the second transfer gates 20A to 20C. Thus, a potential difference is provided to prevent electric charge from flowing backwards in the transfer path of charge.

As shown in Fig. 2, a contact hole 16A is formed in the high-concentration $n^+$-type diffusion layer 16. An electrode (not shown) is formed in the contact hole 16A to be connected to a power source Vss having the maximum potential of the n-channel CCD. Therefore, the high-concentration $n^+$-type diffusion layer 16 and the high-concentration $n^+$-type buried layer 14 are bias, to the potential of the power source Vss.

As shown in Fig. 2, a contact hole 18A is formed in the outputting region 18. An electrode (not shown) is formed in the contact hole 18A to be connected to a ground potential GND. Therefore, the p-type epitaxial layer 15A is biased to the ground potential.

Contact holes 17E and 17H are formed in the high-concentration $n^+$-type diffusion layers 17A and 17D, respectively. Electrodes (not shown) are formed in the contact holes 17E and 17H. Wirings (not shown) are connected to the electrodes, and charges are input and output through the wirings.

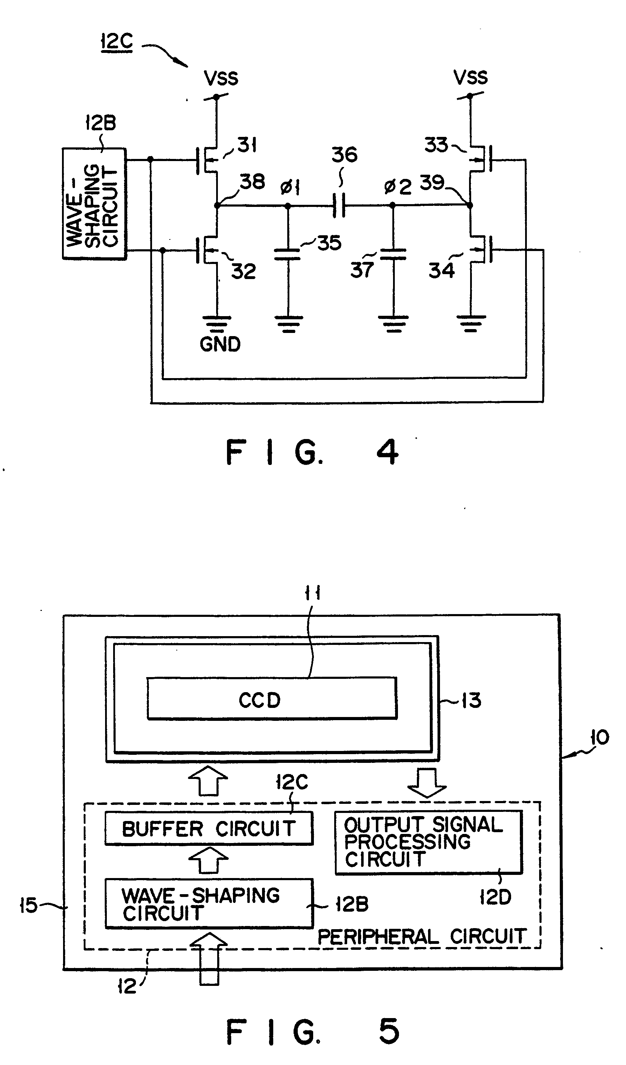

Fig. 4 shows a circuit equivalent to the CCD 11 and the buffer circuit 12C. The CCD 11 is represented by capacitors 35, 36 and 37. Normally, each capacitor 35, 36 and 37 has a high value, e.g. several hundred pF or more.

The buffer circuit 12C comprises n-type MOS transistors 31 to 34. The transistors 31 to 34 constituting the buffer circuit 12C are controlled by an output signal from the wave-shaping circuit 12B, and $n^+$-type diffusion layers 38 and 39 are supplied with clock signals $\phi 1$ and $\phi 2$.

In the above arrangement, an operation of the n-channel CCD 11 will be described.

A transfer charge is input to the high-concentration $n^+$-type diffusion layer 17A through the contact hole 17E shown in Fig. 2. In this state, when a low-level portion of the clock signal $\phi 1$ is supplied to the first transfer gate 19A and the second transfer gate 20A shown in Fig. 3, and a high-level portion of the clock signal $\phi 2$ is supplied to the first transfer gate 19B and the second transfer gate 20B, the charge in the n-type layer under the second transfer gate 20A moves to the n-type layer under the second transfer gate 20B through the $n^-$-type layer under the first transfer gate 19B. Similarly, the charge moves to a region under the first transfer gate 19C and the second transfer gate 20C, and is finally transferred to the high-concentration $n^+$-type diffusion layer 17D. However, since the high-concentration $n^+$-type impurity diffusion layer 16 and the $n^+$-type buried layer 14 biased by the power source Vss surround the p-type epitaxial layer 15A, the clock signal flows to the power source Vss through the parasitic capacitor, the high-concentration $n^+$-type impurity diffusion layer 16, and the $n^+$-type buried layer 14. Therefore, the clock signal is not leaked inside the p-type epitaxial layer 15A.

Since the clock signal is not leaked, as described above, the leakage of the clock signal to the CCD 11 is substantially prevented and the level of the clock signal at the signal output terminal is greatly reduced. Since the peripheral circuit 12 is not adversely affected by the clock signal, high-frequency characteristics of the peripheral circuit 12 are not degraded. A high-reliability, high-performance monolithic semiconductor device consisting of the peripheral circuit 12 and the CCD 11 can be provided.

Note that capacitive coupling hardly occurs between the p-type Si substrate 10, on the one hand, and the $n^+$-type buried layer 14 and the high-concentration $n^+$-type impurity diffusion layer 16, on the other, which is formed to surround the p-type epitaxial layer 15A. This is because a change of potential of the power source Vss is much smaller than that of the clock signals $\phi 1$ and $\phi 2$.

The structure of the CCD 11 is not limited to the above embodiments. The number of stages of the CCD, the method of clocking, the method of inputting/outputting charge, the type of transfer of charge, etc. may be modified. For example, the CCD 11 may be of the surface transfer type or of the buried transfer type.

Fig. 5 shows a second embodiment of the peripheral circuit 12. In Fig. 5, the reference numerals already appearing in Fig. 1 denote the same parts.

In the second embodiment, the input terminal 12E is supplied with a clock signal generated, for example, in a TV set or a VCR. This clock signal is supplied to the wave-shaping circuit 12B. With this structure, the same advantages as in the first embodiment can be attained.

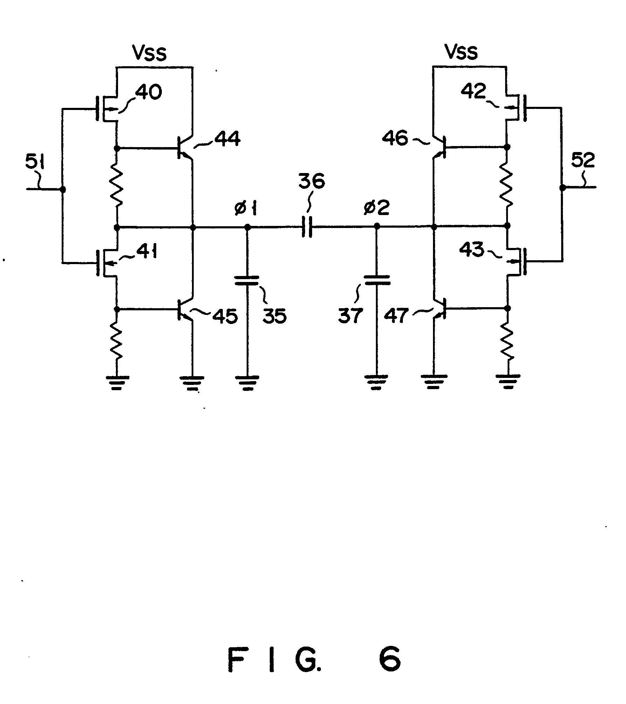

Fig. 6 shows another embodiment of the buffer circuit 12C, wherein the buffer circuit shown in Fig. 4 is constituted by Bi-CMOSs.

In Fig. 6, a MOS transistor 40 and a bipolar transistor 44 correspond to the MOS transistor 31 shown in Fig. 4. A MOS transistor 41 and a bipolar transistor 45 correspond to the MOS transistor 32 shown in Fig. 4. A MOS transistor 42 and a bipolar transistor 46 correspond to the MOS transistor 33 shown in Fig. 4, and a MOS transistor 43 and a bipolar transistor 47 correspond to the MOS transistor 34 shown in Fig. 4. Numerals 52 and 53 denote input terminals for receiving opposite-phase clock signals supplied from a wave-shaping circuit (not shown).

With this structure, the same advantages as in the embodiments can be attained. In addition, since the bipolar transistor, which allows a large current to flow in a small area, is advantageous in driving an element having a large capacitance, such as a CCD.

Reference signs in the claims are intended for better understanding and shall not limit the scope.

## Claims

1. A semiconductor device having a charge transfer device, characterized by comprising:
a semiconductor substrate (10) of a first conductivity type;
a buried layer (14) of a second conductivity type formed in said semiconductor substrate (10);
an epitaxial layer (15) of the first conductivity type formed on said semiconductor substrate (10) and said buried layer (14);
a diffusion layer (16) of the second conductivity type formed in said epitaxial layer (15) to contact the peripheral portion of said buried layer (14);
a charge transfer device (11) formed in said epitaxial layer (15) surrounded by said diffusion layer (16); and
means (Vss) for biasing said diffusion layer (16) and said buried layer (14) connected to said diffusion layer to a potential higher than that of said epitaxial layer (15).

2. A device according to claim 1, characterized by further comprising:
circuit means (12) for exchanging a signal with said charge transfer device (11), said circuit means being formed in a region of said epitaxial layer (15) which is not surrounded by said diffusion layer (16) of the second conductivity type.

3. A device according to claim 2, characterized in that said circuit means (12) includes an oscillator (12A) for oscillating a transfer clock signal for said charge transfer device (11).

4. A device according to claim 2,
characterized in that
said circuit means includes a wave-shaping circuit for generating a transfer clock signal for said charge transfer device, on the basis of an externally input clock signal.

5. A semiconductor device comprising:
a semiconductor main body (10); and
a charge transfer device (11) arranged in a surface region of said semiconductor main body (10);
characterized in that said semiconductor device further comprises:
circuit means (12), formed on said semiconductor main body, for exchanging a signal with said charge transfer device (11); and
means (13), formed in said semiconductor main body, for electrically isolating said charge transfer device (11) from said circuit means (12).

6. A device according to claim 5,
characterized in that
said semiconductor main body (10) is constituted by a semiconductor substrate (10) of a first conductivity type and an epitaxial layer (15) of the first conductivity type formed thereon.

7. A device according to claim 5,
characterized in that
said semiconductor main body (10) is constituted by a semiconductor substrate (10) of the first conductivity type and an epitaxial layer (15) of the first conductivity type formed thereon, and said isolating means (13) is constituted by a buried layer (14) of a second conductivity type formed in said semiconductor main body (10) and a diffusion layer (16) of the second conductivity type which is formed to contact the peripheral portion of said buried layer (14) in said epitaxial layer (15).

8. A device according to claim 7,
characterized by further comprising:
means (12) for biasing said isolating means (12) to a potential higher than that of said epitaxial layer (15).

9. A device according to claim 5,
characterized in that
said circuit means (12) includes an oscillator (12A) for oscillating a transfer clock signal for said charge transfer device (11).

10. A device according to claim 5,
characterized in that
said circuit means includes a wave-shaping circuit for generating a transfer clock signal for said charge transfer device, on the basis of an externally input clock signal.

F I G.　1

13    16    15    15A

3 ←

16A    18A    17E    19A    20A    20B    20C    17H
                              19B    19C
                                              17D

18    17A

→ 3

11

## F I G.    2

VSS GND    ∅1    ∅2    ∅1

20A 19B    20B    20C
15  13  16    19A    19C    15A  16  15

18 P⁺    n⁺ n⁻ n  n⁻ n  n⁻ n  n⁺    17D
17A

n⁺

10    14

## F I G.    3

F I G. 4

F I G. 5

F I G.   6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 9, no. 291 (E-359)(2014) 19 November 1985, & JP-A-60 132367 (NIPPON DENKI K.K.) 15 July 85, * the whole document * | 1-2, 5-8 | H01L29/796 G11C19/28 |
| Y | | 3-4, 9-10 | |
| Y | DE-A-2808558 (TOSHIBA) * page 5, paragraph 1 - page 6, paragraph 3 * * page 9, paragraph 2; figure 5 * | 3-4, 9-10 | |
| A | DE-A-2655400 (HITACHI) * page 14, last paragraph - page 15, paragraph 1; figure 1 * | 1, 5-7 | |

TECHNICAL FIELDS SEARCHED (Int. Cl.5 )

H01L
G11C

The present search report has been drawn up for all claims

| Place of search | Date of completion of the search | Examiner |
|---|---|---|
| BERLIN | 02 MAY 1990 | MUNNIX, S |

EPO FORM 1503 03.82 (P0401)